# EUROPÄISCHE PATENTSCHRIFT

(11) **EP 1 285 483 B1**
(45) Veröffentlichungstag und Bekanntmachung des Hinweises auf die Patenterteilung: **04.08.2004**
(21) Anmeldenummer: 01943049.5
(22) Anmeldetag: 10.05.2001
(51) Int. Cl.: H02H 9/02, H03K 17/82

(54) **HALBLEITER-BAUELEMENT**
SEMICONDUCTOR COMPONENT
COMPOSANT SEMI-CONDUCTEUR

(30) Priorität: 16.05.2000 DE 10023950
(43) Veröffentlichungstag der Anmeldung: 26.02.2003
(73) Patentinhaber: ROBERT BOSCH GMBH, 70442 Stuttgart (DE)
(72) Erfinder: WRANA, Michael, 12207 Berlin (DE)
(86) Internationale Anmeldenummer: PCT/DE2001/001773
(87) Internationale Veröffentlichungsnummer: WO 2001/089053

(56) Entgegenhaltungen:
- EP-A- 0 432 847
- EP-A- 0 755 076
- EP-A- 0 814 395
- DE-A- 3 037 957
- DE-A- 19 805 734
- JP-A- 1 220 915
- JP-A- 9 046 143
- JP-A- 11 326 400
- JP-U- 4 032 543
- US-A- 5 550 702
- US-E- R E33 941
- PATENT ABSTRACTS OF JAPAN vol. 2000, no. 05, 14. September 2000 (2000-09-14) & JP 2000 053070 A (SANYO ELECTRIC CO LTD), 22. Februar 2000 (2000-02-22)
- PATENT ABSTRACTS OF JAPAN vol. 1997, no. 02, 28. Februar 1997 (1997-02-28) & JP 08 272459 A (SANYO ELECTRIC CO LTD), 18. Oktober 1996 (1996-10-18)
- PATENT ABSTRACTS OF JAPAN vol. 013, no. 564 (E-860), 14. Dezember 1989 (1989-12-14) & JP 01 235362 A (SANYO ELECTRIC CO LTD), 20. September 1989 (1989-09-20)
- PATENT ABSTRACTS OF JAPAN vol. 2000, no. 01, 31. Januar 2000 (2000-01-31) & JP 11 299218 A (MITSUBISHI ELECTRIC CORP), 29. Oktober 1999 (1999-10-29)
- PATENT ABSTRACTS OF JAPAN vol. 1999, no. 07, 31. März 1999 (1999-03-31) & JP 03 003509 A (NATL SEMICONDUCTOR CORP <NS>), 9. Januar 1991 (1991-01-09)

## Beschreibung

### Stand der Technik

Die Erfindung betrifft ein Halbleiter-Bauelement mit einem Leistungsschalter, an den eine Last angeschlossen werden kann, und mit einer Senseschaltung und einer Auswerteschaltung zur Erfassung und Auswertung des durch den Leistungsschalter fließenden Laststroms.

Der elektrische Zustand eines Halbleiter-Leistungsschalters läßt sich durch Messung des durch diesen Leistungsschalter fließenden Laststroms charakterisieren. Derartige Strommessungen haben in der Praxis im wesentlichen drei Funktionen. Erstens kann der Leistungsschalter im Fall der Detektion eines zu hohen Laststroms automatisch abgeschaltet werden. Durch Unterbrechung des Laststroms wird sowohl der Leistungsschalter selbst als auch die angeschlossene Last vor schädigenden Überströmen geschützt. Zweitens kann durch Messung des Laststroms und geeignete Rückkopplung des Meßsignals auf den Eingang des Leistungsschalters eine Strombegrenzung bzw. -regelung realisiert werden, die einen konstanten Stromfluss durch die Last und den Leistungsschalter ermöglicht. Drittens kann das jeweils aktuell gemessene Stromniveau auch als Stromstatussignal ausgegeben werden.

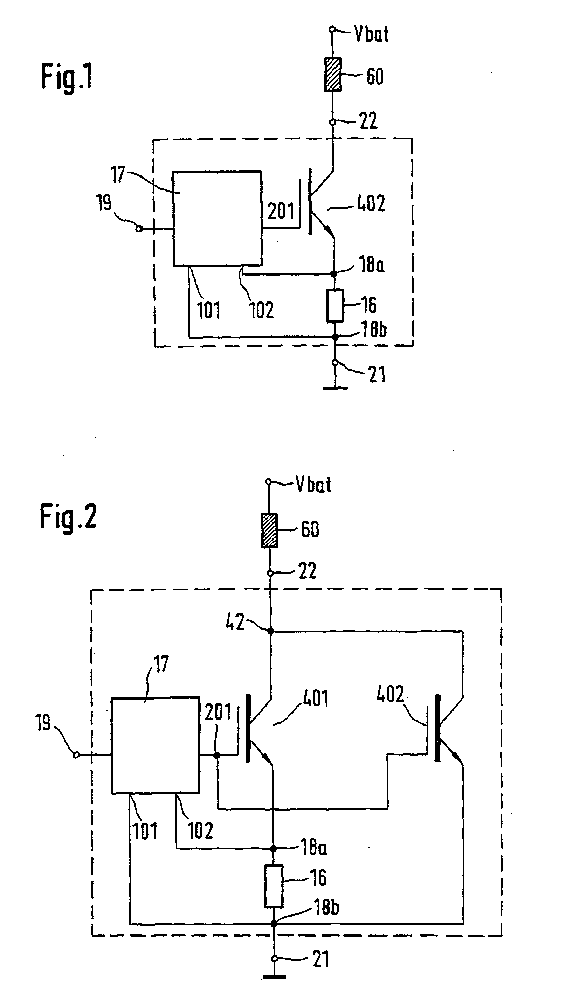

In der Druckschrift Z. J. Shen, S. P. Robb, "Monolithic Integration of the Vertical IGBT and Intelligent Protection Circuits", ISPSD 1996, Proceedings, Seiten 295 bis 298 wird ein Konzept für die Strommessung beschrieben, das sich als besonders geeignet für die monolithische Integration eines Stromsensors, d. h. die Senseschaltung und die Auswerteschaltung, auf dem Leistungsschalter-Chip erwiesen hat. Die aus dieser Druckschrift bekannten Schaltungsanordnungen mit einem Lowside-Schalter werden in Verbindung mit den Figuren 1 und 2 näher erläutert.

Als steuerbare Leistungsschalter 402 (Fig. 1) bzw. 401 und 402 (Fig. 2) kommen DMOS-Transistoren, Bipolartransistoren und Insulated Gate Bipolar Transistoren (IGBT) in Betracht. Die mit den gestrichelten Linien umrandeten Strukturen sind jeweils auf einem Chip integriert. Über die Hochspannung führende Elektrode 22 ist eine Last 60 an den Leistungsschalter 402 bzw. 401/402 angeschlossen, die aus einem resistiven und/oder induktiven Element bestehen kann. Der Laststrom fließt von der Versorgungsspannungsquelle Vbat durch die Last 60 über die Hochspannung führende Elektrode 22 durch den Leistungsschalter 402 bzw. 401/402 über einen ohmschen Widerstand 16 und die Niederspannung führende Elektrode 21 zum Massepunkt. Mit Hilfe eines Eingangssignals am Kontakt 201 des Leistungsschalters 402 bzw. 401/402 kann der Laststrom gesteuert werden. Der ohmsche Widerstand 16 soll im folgenden als Sensewiderstand bezeichnet werden. Der Spannungsabfall über dem Sensewiderstand 16 dient hier als Maß für den Laststrom. Die Spannung über dem Sensewiderstand 16 wird an den Punkten 18A und 18B abgegriffen und einer Auswerteschaltung 17 über die Klemmen 101 und 102 zugeführt. Die Auswerteschaltung 17 kann nun ein den voranstehend genannten Zielen der Stromsensierung entsprechendes Eingangssignal an der Elektrode 201 des Leistungsschalters 402 bzw. 401/402 generieren. Im Falle der Detektion eines zu hohen Laststroms kann der Leistungsschalter 402 bzw. 401/402 abgeschaltet werden oder auch so geregelt werden, dass ein unschädlicher Stromfluss durch die Last 60 und den Leistungsschalter 402 bzw. 401/402 gewährleistet ist. Schließlich kann die Auswerteschaltung 17 hier auch noch ein Stromstatussignal ausgeben.

Der zusätzliche Spannungsabfall am Sensewiderstand 16 erzeugt im Lastkreis einen erhöhten Energieverlust. Bei der in Fig. 2 dargestellten Variante wird der Energieverlust dadurch verringert, dass der Leistungsschalter in zwei flächenmäßig unterschiedlich große Teilzellen 401 und 402 aufgeteilt ist. Der Sensewiderstand 16 ist hier lediglich in den Massezweig der flächenmäßig kleineren Teilzelle 401 eingefügt, die im folgenden als Sensezelle bezeichnet wird. Der dadurch bedingte geringere Stromfluss durch den Sensewiderstand erzeugt auch einen geringeren Energieverlust im Leistungsschalter insgesamt.

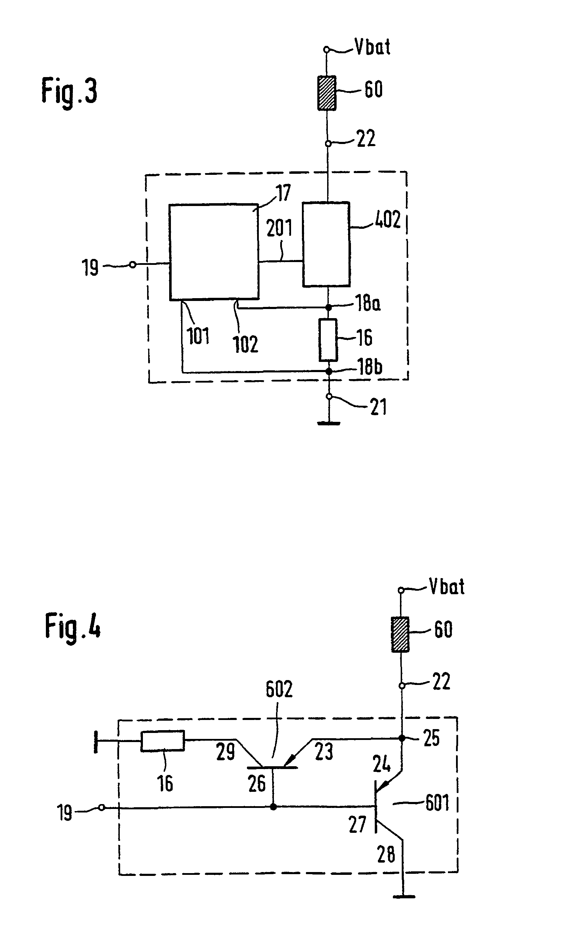

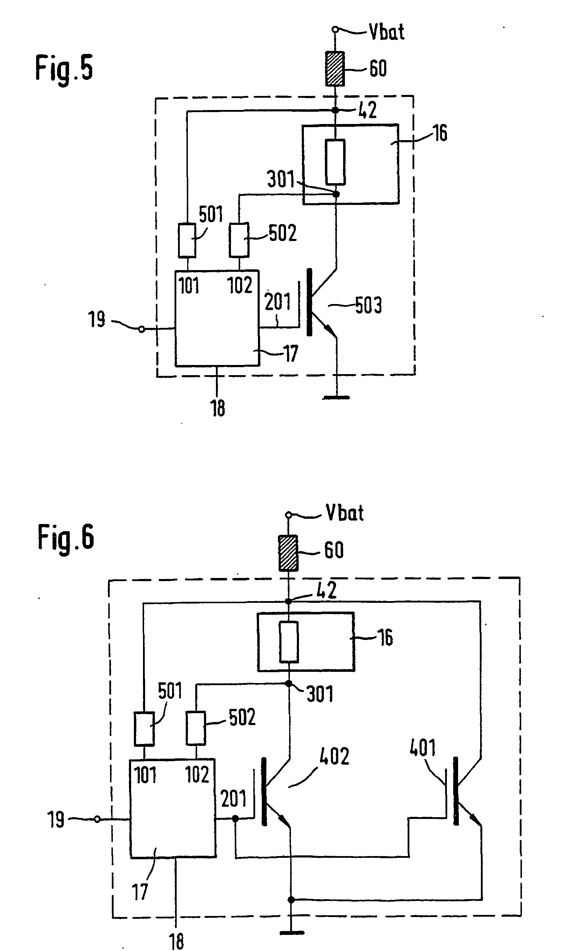

In der Praxis erweist sich das voranstehend erörterte Konzept als problematisch, was am Beispiel eines Bipolartransistors in Verbindung mit den Figuren 3 und 4 nachfolgend erläutert wird. In diesen Figuren werden teilweise die gleichen Bezugszeichen verwendet wie in den Figuren 1 und 2, wobei gleiche Bezugszeichen gleiche Schaltungselemente bezeichnen.

Der Stromfluss durch den Sensewiderstand 16 setzt sich aus der Summe des Laststromes durch die Last 60, die Hochspannung führende Elektrode 22 und den Leistungsschalter 402 sowie den Ansteuerstrom über Anschluß 201 des Leistungsschalters 402 zusammen. Somit besteht z. B. für den Fall eines Bipolartransistors keine lineare Beziehung zwischen dem Laststrom und der Spannung am Sensewiderstand 16, so dass die Spannung am Sensewiderstand 16 den Laststrom nicht direkt repräsentiert. Dies erweist sich insbesondere bei Halbleiter-Bauelementen als problematisch, deren Stromfluss sich von der die Hochspannung führenden Elektrode aus im Bauelement in mehrere Strompfade zum Massepunkt hin aufteilt, bei denen aber lediglich ein Pfad für die Strommessung gemäß dem in den Figuren 1 und 2 dargestellten Sensierungskonzept zur Verfügung steht. Die Tatsache, dass der Zusammenhang zwischen Laststrom und Spannung am Sensewiderstand in diesen Fällen nicht linear ist, hat einen gravierenden Einfluss auf die Regelbarkeit des Laststroms, was anhand des in Fig. 4 dargestellten Leistungsbauelements mit zwei Strompfaden erläutert werden soll.

Das hier dargestellte Leistungsbauelement umfasst zwei pnp-Bipolartransistoren 601 und 602, deren Emitter 23 und 24 im Kontakt 25 verbunden sind und deren Basen 26 und 27 von einer gemeinsamen Elektronenquelle über Anschluss 19 angesteuert werden. Beide pnp-Bipolartransistoren 601 und 602 zeichnen sich durch verschiedene Verstärkungsfaktoren aus. Die Last 60 ist zwischen die Hochspannung führende Elektrode 22, die den gemeinsamen äußeren Emitteranschluss bildet, und die Versorgungsspannung Vbat geschaltet. In dem in Fig. 4 dargestellten Fall ist entsprechend dem bekannten Stromsensierungskonzept nur ein Sensewiderstand 16 an den Kollektor 29 des Bipolartransistors 602 gegenüber Masse geschaltet. Da der Kollektor 28 des Transistors 601 die Chip-Rückseite darstellt, kann hier kein Sensewiderstand zwischen den Kollektor 28 und die Masse geschaltet werden. Der Spannungsabfall am Sensewiderstand 16 repräsentiert hier also nur eine Komponente des durch den Leistungsschalter insgesamt fließenden Laststroms. Die zweite Komponente kann mit dem bisherigen Verfahren nicht gemessen oder bestimmt werden. Da es im allgemeinen auch keinen einfachen mathematisch beschreibbaren Zusammenhang zwischen dem Strom durch den Sensewiderstand 16 und dem Laststrom durch den Leistungsschalter insgesamt gibt, kann der Laststrom mit dem bekannten Verfahren nicht zuverlässig bestimmt werden.

Dies wirkt sich insbesondere negativ auf den Entwurf einer Stromregelung aus. Bedingt durch die beiden Transistorpfade mit unterschiedlichen nicht linearen Zusammenhängen zwischen der jeweiligen Stromverstärkung und dem entsprechenden Kollektorstrom kann der Fall eintreten, dass der Strom durch den Sensewiderstand 16 abnimmt, während der Laststrom zunimmt. So kann die Stromverstärkung des Bipolartransistors 602 beispielsweise aufgrund der Hochinjektion abnehmen, während die Stromverstärkung des Bipolartransistors 601 mit dem Kollektorstrom noch ansteigt. Die Reduktion des Spannungsabfalls am Sensewiderstand 16 würde in diesem Falle eine Verringerung des Laststroms vortäuschen, obwohl der Laststrom weiterhin ansteigt. Eine sinnvolle Regelung des Laststroms durch den Leistungsschalter allein auf der Grundlage der über dem Sensewiderstand abgegriffenen Spannung ist hier also nicht möglich.

Es wird nun ein Halbleiter-Bauelement mit einem Leistungsschalter vorgeschlagen, bei dem der durch den Leistungsschalter fließende Laststrom zuverlässig und mit hoher Genauigkeit gemessen werden kann. Dies ermöglicht eine zuverlässige Abschaltung des Leistungsschalters im Falle von Überströmen, eine zuverlässige und genaue Regelung des Laststroms sowie die Ausgabe eines zuverlässigen Stromstatussignals.

Die Druckschrift JP 04 032543 U zeigt eine Highside-Schaltung mit einem Power-MOSFET, bei der ein Strommesswiderstand zwischen Power-MOSFET und Last geschaltet ist. Ein Verstärker CM2 mißt die Spannung über dem Strommesswiderstand. Der Strommesswiderstand ist - siehe Figur 1 - monolithisch mit dem Power-MOSFET integriert.

### Vorteile der Erfindung

Eine zuverlässige und genaue Messung des Laststroms durch den Leistungsschalter eines Halbleiter-Bauelements wird erfindungsgemäss mit einem Halbleiter-Bauelement, wie im Anspruch 1 definiert, erreicht. Es enthält einen Lowside-Leistungsschalter, bei dem die Senseschaltung hochspannungsseitig an den Leistungsschalter angeschlossen ist, also zwischen Last und Leistungsschalter geschaltet ist.

Erfindungsgemäß ist erkannt worden, dass auf diese Weise sehr einfach der gesamte Laststrom erfasst werden kann, unabhängig von einer etwaigen Stromaufteilung im Leistungsschalter in mehrere Strompfade. Erfindungsgemäß ist es also möglich, den tatsächlichen Laststrom zu erfassen und einer Stromregelung zugrundezulegen, auch ohne quantitative Kenntnis der Stromaufteilung im Bauelement.

In einer besonders vorteilhaften. Variante des erfindungsgemäßen Halbleiter-Bauelements umfasst die Senseschaltung einen Sensewiderstand, der in Reihe mit der Last geschaltet ist. Der Laststrom kann dann einfach über den Spannungsabfall am Sensewiderstand ermittelt werden. Dazu wird die Spannung über dem Sensewiderstand als Sensesignal abgegriffen und der Auswerteschaltung des Halbleiter-Bauelements zugeführt. Im Extremfall kann die gesamte Senseschaltung also aus einem einzigen Sensewiderstand bestehen, der in einer vorteilhaften Variante des erfindungsgemäßen Halbleiter-Bauelements monolithisch auf dem Chip des Leistungsschalters integriert ist. Der Sensewiderstand könnte in diesem Falle vorteilhafter Weise aus einem halbleitenden Material, vorzugsweise aus Polysilizium, gebildet sein. Alternativ könnte der Sensewiderstand aber auch in Form einer Metallisierung realisiert sein.

Im Hinblick auf einen Schutz der Auswerteschaltung vor Überströmen ist es von Vorteil, wenn das Sensesignal der Auswerteschaltung über hochohmige Widerstände zugeführt wird. Im Falle einer induktiven Last steigt das Potential an den Spannungsabgriffen über dem Sensewiderstand beim Abschalten des Leistungsschalters dynamisch rapide an, was ohne entsprechende Ausgestaltung der Zuführungen zu einer Zerstörung der Auswerteschaltung führen kann. Vorteilhafterweise sind auch diese hochohmigen Widerstände monolithisch auf dem Chip des Leistungsschalters integriert. Vorteilhafterweise sind die hochohmigen Widerstände in diesem Falle aus einem halbleitenden Material, vorzugweise aus Polysilizium, gebildet.

Im Hinblick auf eine Verringerung der Verlustenergie durch den Sensewiderstand ist es vorteilhaft, wenn der Leistungsschalter in einen flächenmäßig kleineren Teil und einen flächenmäßig größeren Teil aufgeteilt ist, wobei der flächenmäßig kleinere Teil die Sensezelle und der flächenmäßig größere Teil die Hautzelle des Leistungsschalters bildet. Der Sensewiderstand ist in diesem Falle zwischen die Last und die Sensezelle geschaltet, während die Hauptzelle direkt an die Last angeschlossen ist. Die Hauptzelle und die Sensezelle sollen vorzugweise ähnliche elektrische Arbeitspunkte haben, was beispielsweise dadurch erreicht werden kann, dass der Spannungsabfall am Sensewiderstand klein gegenüber der Potentialdifferenz zwischen dem lastseitigen Spannungsabgriff am Sensewiderstand und Masse ist.

Die Sensezelle des erfindungsgemäßen Halbleiter-Bauelements kann z. B. im Fall eines IGBTs als Leistungsschalter grundsätzlich einen beliebigen Teil eines Anodenfingers des Leistungsschalters umfassen, wobei die Anodendiffusion des Anodenfingers zwischen der Sensezelle und der Hauptzelle unterbrochen ist, um die Sensezelle von der Hauptzelle zu trennen und einen Stromfluss parallel zum Sensewiderstand zu vermeiden. Im Hinblick auf ein einfaches und übersichtliches Layout ist es von besonderem Vorteil, wenn die Sensezelle die Spitze des Anodenfingers umfasst. Der Sensewiderstand kann dann einfach zwischen der Anodenmetallisierung der Sensezelle und der Anodenmetallisierung der Hauptzelle angeordnet werden.

Im Falle eines Bipolartransistors als Leistungsschalter erweist es sich als vorteilhaft, wenn die Sensezelle einen Teil des Emitters des Bipolartransistors umfasst und der Sensewiderstand einerseits mit dem Emitter der Sensezelle und andererseits mit dem Emitter der Hauptzelle verbunden ist. Im Falle eines DMOS-Transistors ist es von Vorteil, wenn die Sensezelle einen Teil des Draingebiets des DMOS-Transistors umfasst und der Sensewiderstand einerseits mit dem Draingebiet der Sensezelle und andererseits mit dem Draingebiet der Hauptzelle verbunden ist. Im Falle eines lateralen oder lateralen/vertikalen IGBTs erweist es sich als vorteilhaft, wenn die Sensezelle einen Teil der Anode des IGBTs umfasst und der Sensewiderstand einerseits mit der Anode der Sensezelle und andererseits mit der Anode der Hauptzelle verbunden ist.

Wie bereits erwähnt, gibt es verschiedene Möglichkeiten, die Lehre der vorliegenden Erfindung in vorteilhafter Weise auszugestalten und weiterzubilden. Dazu ist einerseits auf die dem Patentanspruch 1 nachgeordneten Ansprüche und andererseits auf die nachfolgende Erläuterung mehrerer Ausführungsbeispiele der Erfindung anhand der Zeichnungen, insbesondere Figuren 5 bis 9, zu verweisen.

### Zeichnungen

Fig. 1 zeigt eine Schaltungsanordnung mit einem Lowside-Schalter.
Fig. 2 zeigt eine weitere Schaltungsanordnung, bei der der Leistungsschalter in zwei flächenmäßig sehr unterschiedlich große Teilzellen aufgeteilt ist.
Fig. 3 zeigt eine Schaltungsanordnung gemäß Fig. 1 mit dem allgemeinen Fall als Leistungsschalter.
Fig. 4 zeigt die Struktur eines Leistungsbauelements mit zwei Strompfaden.
Fig. 5 zeigt die Schaltungsanordung eines erfindungsgemäßen Halbleiter-Bauelements.
Fig. 6 zeigt die Schaltungsanordnung eines weiteren erfindungsgemäßen Halbleiter-Bauelements.
Fig. 7 zeigt den Querschnitt durch die Struktur eines erfindungsgemäßen Halbleiter-Bauelements mit einem IGBT als Leistungsschalter.
Fig. 8 zeigt die Aufsicht auf das in Fig. 7 im Querschnitt dargestellte Halbleiter-Bauelement.
Fig. 9 zeigt den Querschnitt zwischen der Anode und der Sensezelle des in den Figuren 7 und 8 dargestellten Halbleiter-Bauelements.

In den Figuren 5 bis 9 wurden bereits in den Figuren 1 bis 4 dargestellte Schaltungselemente mit denselben Bezugszeichen versehen, wie in den Figu ren 1 bis 4.

### Beschreibung der Ausführungsbeispiele

Bei dem in Fig. 5 dargestellten Leistungsschalter 503 kann es sich um ei nen IGBT oder auch einen DMOS-Transistor oder Bipolartransistor handeln. Im Gegensatz zu dem in Verbindung mit den Figuren 1 bis 4 beschriebenen Stromsensierungskonzept ist der Sensewiderstand 16 hier hochspannungsseitig an den Leistungsschalter 503 angeschlossen, so dass er in Reihe mit der Last 60 geschaltet ist. Der Laststrom wird über den Spannungsabfall am Sensewiderstand 16 erfasst, unabhängig von einer etwaigen Stromaufteilung im Leistungsschalter in mehrere Strompfade. Dazu sind die Spannungsabgriffe 42 und 301 vorgesehen, die über hochohmige Widerstände 501 und 502 an die Eingänge 101 und 102 der Auswerteschaltung 17 geführt sind. Die Auswerteschaltung 17 ermittelt aus dem den Spannungsabfall über dem Sensewiderstand 16 entsprechenden Sensesignal den tatsächlichen Laststrom und kann im Bedarfsfalle den Laststrom durch Generieren eines entsprechenden Eingangssignals an der Elektrode 201 des Leistungsschalters 503 regeln. Des Weiteren kann die Auswerteschaltung 17 ein Stromstatussignal am Ausgang 18 erzeugen. Durch die gestrichelte Linie wird angedeutet, dass der Leistungsschalter 503 zusammen mit dem Sensewiderstand 16, den hochohmigen Widerständen 501 und 502 und der Auswerteschaltung 17 auf einem Chip monolithisch integriert ist. Der Sensewiderstand 16 und auch die hochohmigen Widerstände 501 und 502 könnten dazu aus Polysilizium hergestellt sein.

Wie bereits voranstehend erläutert, ist es im Hinblick auf die Verringerung der Verlustenergie günstig, den Leistungsschalter, wie in Fig. 6 dargestellt, in einen flächenmäßig kleineren Teil 402 und einen flächenmäßig größeren Teil 401 aufzuteilen, wobei der flächenmäßig kleinere Teil 402 eine Sensezelle bildet und hochspannungsseitig an den Sensewiderstand 16 angeschlossen ist, während der flächenmäßig größere Teil 401 die Hauptzelle des Leistungsschalters bildet und hochspannungsseitig direkt mit der Last 60 verbunden ist. Dementsprechend fließt der größere Stromanteil durch den Leistungsschalter über den Hauptteil 401, der lediglich am Knoten 42 mit dem Sensewiderstand 16 verbunden ist. Die Sensezelle 402, d. h. der flächenmäßig kleinere Teil des Leistungsschalters, wird aus einer Anodenfingerspitze gebildet und ist über den in Form eines Polysiliziumwiderstandes realisierten Sensewiderstand 16 mit der Hauptzelle 401, d. h. dem flächenmäßig größeren Teil des Leistungsschalters verbunden. Die Hauptzelle 401 und die Sensezelle 402 haben vorzugsweise ähnliche elektrische Arbeitspunkte, was einfach dadurch erreicht werden kann, dass der Spannungsabfall am Sensewiderstand 16 klein gegenüber der Potentialdifferenz zwischen dem Knoten 42 und Masse ist. Auch im hier dargestellten Fall ist es also ohne quantitave Kenntnis der Stromaufteilung möglich, den Laststrom zu erfassen.

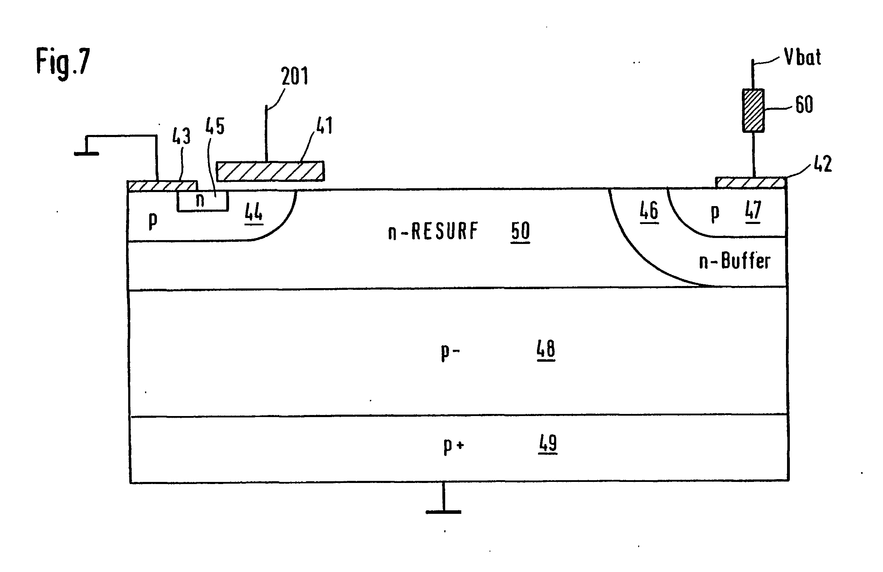

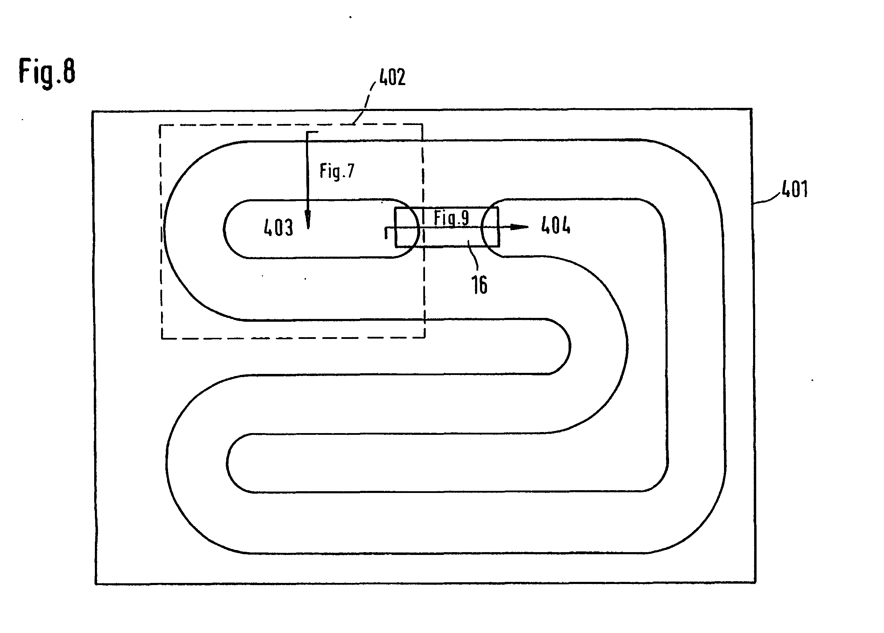

In Verbindung mit den Figuren 7 bis 9 wird nachfolgend ein konkretes Ausführungsbeispiel für ein erfindungsgemäßes Halbleiter-Bauelement beschrieben, wobei der Leistungsschalter durch einen IGBT mit lateralem und vertikalem Strompfad gebildet ist. Fig. 7 zeigt einen Querschnitt durch die Struktur dieses Bauelements. Der Anodenanschluss 42 des dargestellten IGBTs ist mit einer induktiven Last 60 verbunden, die von einer Versorungsspannungsquelle Vbat gespeist wird. Der laterale Kathodenkontakt 43 des IGBTs und die Chip-Rückseite sind mit Masse verbunden. Im hier dargestellten Ausführungsbeispiel ist der IGBT auf einem p⁺-Substrat 49 mit einer niederohmigen p⁻-Epitaxieschicht 48 realisiert, an die sich ein n-RESURF-Gebiet anschließt. Alternativ könnte der IGBT aber auch auf einem p⁻-Substrat realisiert sein, in das durch eine entsprechende Diffusion auf der Waferrückseite eine p⁺-Schicht eingebracht worden ist und auf dem eine n-RESURF-Schicht an der Waferoberseite erzeugt worden ist. Im hier dargestellten Ausführunsbeispiel ist die Anode in Form einer p-Diffusion 47 und einer diese umschließenden n-Buffer-Diffusion 46 realisiert, um die Sperrfestigkeit des Bauelements zu erhöhen. Die laterale Kathode ist in Form einer p-Diffusion 44 und einem n-Gebiet 45 innerhalb der p-Diffusion 44 gebildet. Durch Anlegen einer positiven Spannung an das Gate 41 des IGBTs über die Leitung 201 bildet sich an der Halbleiteroberfläche unterhalb des Gates 41 in der p-Diffusion 44 eine Inversionsschicht aus, so dass Elektronen in das n-RESURF-Gebiet 50 injiziert werden können. Daraufhin antwortet die Anoden-p-Difffusion 47 mit einer Injektion von Löchem in das n-RESURF-Gebiet 50 und in die p⁻-Epitaxieschicht 48, wobei sich durch Hochinjektion eine Leitfähigkeitsmodulation in beiden Gebieten ergibt. Der Laststrom teilt sich dabei im Bauelement in einen vertikalen und einen lateralen Strompfad auf.

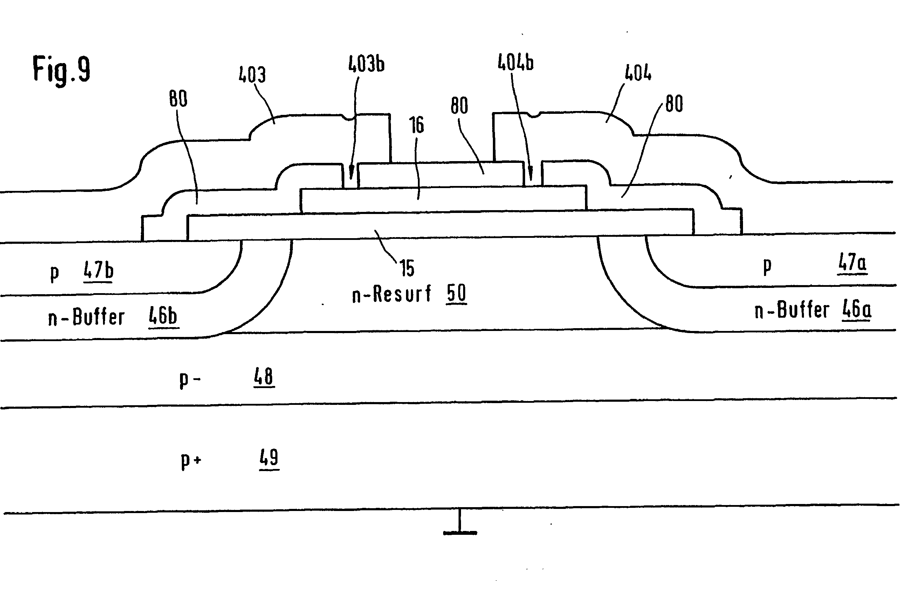

Fig. 8 zeigt die Auffsicht auf die in Fig. 7 dargestellte Endstufe und verde utlicht die geometrische Anordnung des monolithisch in einen Chip integrierten IGBTs mit einer Hauptzelle 401 und einer Sensezelle 402 sowie des in denselben Chip integrierten Sensewiderstandes 16. Die Sensezelle 402 wird hier aus der Spitze eines Anodenfingers gebildet, dessen Metallisierung 403 über den Sensewide rstand 16 mit der Anodenmetallisierung 404 der Hauptzelle 401 verbunden ist. Fig. 9 zeigt den Querschnitt durch das in den Figuren 7 und 8 dargestellte Halbleiter-Bauelement zwischen der Anode der Sensezelle 402 und der Anode der Hauptzelle 401. Die Anordnung der Anodendiffusionen und Halbleiterschichtfolgen wurde bereits in Verbindung mit Fig. 7 beschrieben. Unterhalb des Sensewiderstandes 16 sind der n-Buffer 46 und die p-Anodendiffusion 47 unterbrochen, was mit den Bezugszeichen 46A und 46B sowie 47A und 47B angedeutet ist. Auf diese Weise werden die Sensezelle 402 und die Hauptzelle 401 voneinander getrennt, um einen parallelen Stromfluss zum Sensewiderstand 16 zu vermeiden. Der Sensewiderstand 16 besteht im hier dargestellten Ausführungsbeispiel aus Polysilizium, das auf einem Feldoxyd 15 über dem n-RESURF-Gebiet 50 abgeschieden und strukturiert ist. Die Anodenmetallisierungen 403 und 404 werden über Kontaktlöcher 403B und 404B an den Sensewiderstand 16 angeschlossen. Aus Fig. 8 ergibt sich, dass die Anodenmetallisierungen 403 und 404 an ihren Enden Verrundungen aufweisen, um die Sperrfähigkeit des Leistungsbauelements nicht zu begrenzen.

## Patentansprüche

1. Halbleiter-Bauelement mit einem Lowside-Leistungsschalter (503), bei dem die Steuerspannung auf Masse besogen ist und an den eine Last (60) angeschlossen werden kann, und mit einer Senseschaltung (16) und einer Auswerteschaltung (17) zur Erfassung und Auswertung des durch den Leistungsschalter (503) fließenden Laststromes, **dadurch gekennzeichnet, dass** die Senseschaltung (16)auf dem Chip des Leistungsschalters (503) monolithisch integriert ist und die Senseschaltung (16) hochspannungsseitig an den Leistungsschalter (503) angeschlossen ist, dass das Senssignal der Auswerteschaltung (17) über hochohmige Widerstände (501, 502) zugeführt wird und dass die hochohmige Widerstände (501, 502) auf dem Chip des Leistungsschalters (503) monolithisch integriert sind und dass der Leistungsschalter in einen flächenmäßig kleinen Teil (402) und einen flächenmäßig größeren Teil (401) aufgeteilt ist, wobei der flächenmäßig kleinere Teil mindestens eine Sensezelle (402) und der flächenmäßig größere Teil die Hauptzelle (401) des Leistungsschalters bildet.

2. Halbleiter-Bauelement nach Anspruch 1, **dadurch gekennzeichnet, dass** die Senseschaltung einen Sensewiderstand (16) umfaßt, in Reihe mit der Last (60) geschaltet ist und dass die Spannung über dem Sensewiderstand (16) als Sensesignal abgegriffen und der Auswerteschaltung (17) zugeführt wird.

3. Halbleiter-Bauelement nach Anspruch 2, **dadurch gekennzeichnet, dass** der Sensewiderstand (16) aus einem halbleitenden Material, vorzugsweise aus Polysilizium, gebildet ist.

4. Halbleiter-Bauelement nach einem der Ansprüche 1 oder 2, **dadurch gekennzeichnet, dass** der Sensewiderstand aus Metall gebildet ist.

5. Halbleiter-Bauelement nach Anspruch 4, **dadurch gekennzeichnet, dass** die hochohmigen Widerstände (501, 502) aus einem halbleitenden Material, vorzugsweise aus Polysilizium, gebildet sind.

6. Halbleiter-Bauelement nach einem der Anspräche 4 oder 5, **dadurch gekennzeichnet, dass** der Sensewiderstand (16) zwischen die Last (60) und die Sensezelle (402) geschaltet ist und die Hauptzelle (401) direkt an die Last (60) angeschlossen ist.

7. Halbleiter-Bauelement nach Anspruch 6, **dadurch gekennzeichnet, dass** die Sensezelle (402) und die Hauptzelle (401) ähnliche elektrische Arbeitspunkte haben, indem der Spannungsabfall über dem Sensewiderstand (16) klein ist gegenüber der Potentialdifferenz zwischen dem lastseitigen Spannungsabgriff (42) am Sensewiderstand (16) und Masse.

8. Halbleiter-Bauelement nach einem der Ansprüche 6 oder 7, **dadurch gekennzeichnet, dass** die Sensezelle (402) einen Teil des Hochspannung führenden Fingers des Leistungsschalters umfaßt, wobei die den hochspannungsseitigen Finger bildende Diffusion des Hochspannung führenden Fingers zwischen der Sensezelle (402) und der Hauptzelle (401) unterbrochen ist.

9. Halbleiter-Bauelement nach Anspruch 8, **dadurch gekennzeichnet, dass** die Sensezelle (402) die Spitze des Hochspannung führenden Fingers umfaßt.

10. Halbleiter-Bauelement nach einem der Ansprüche 8 oder 9, **dadurch gekennzeichnet, dass** der Sensewiderstand (16) zwischen der Metallisierung des Hochspannung führenden Fingers (403) der Sensezelle (402) und der Metallisierung des Hochspannung führenden Fingers (404) der Hauptzelle (401) angeordnet ist.

11. Halbleiter-Bauelement mit einem Bipolartransistor als Leistungsschalter nach einem der Ansprüche 6 bis 10, **dadurch gekennzeichnet, dass** die Sensezelle einen Teil des Emitters des Bipolartransistors umfaßt und dass der Sensewiderstand einerseits mit dem Emitter der Sensezelle und andererseits mit dem Emitter der Hauptzelle verbunden ist.

12. Halbleiter-Bauelement mit einem DMOS-Transistor als Leistungsschalter nach einem der Anspräche 6 bis 10, **dadurch gekennzeichnet, dass** die Sensezelle einen Teil des Draingebiets des DMOS-Transistors umfaßt und dass der Sensewiderstand einerseits mit dem Draingebiet der Sensezelle und andererseits mit dem Draingebiet der Hauptzelle verbunden ist.

13. Halbleiter-Bauelement mit einem lateralen Insulated Gate Bipolar Transistor IGBT als Leistungsschalter nach einem der Ansprüche 6 bis 10, **dadurch gekennzeichnet, dass** die Sensezelle einen Teil der Anode des lateralen IGBTs umfaßt und dass der Sensewiderstand einerseits mit der Anode der Sensezelle und andererseits mit der Anode der Hauptzelle verbunden ist.

14. Halbleiter-Bauelement mit einem lateralen/vertikalen Insulated Gate Bipolar Transistor IGBT als Leistungsschalter nach einem der Ansprüche 6 bis 10, **dadurch gekennzeichnet, dass** die Sensezelle einen Teil der Anode des lateralen/vertikalen IGBTs umfaßt und dass der Sensewiderstand einerseits mit der Anode der Sennsezelle und andererseits mit der Anode der Hauptzelle verbunden ist.

15. Halbleiter-Bauelement nach einem der Ansprüche 1 bis 14, **dadurch gekennzeichnet, dass** der Strom durch den Leistungsschalter (503) mit Hilfe der Auswerteschaltung (17) regelbar ist.

16. Halbleiter-Bauelement nach einem der Ansprüche 1 bis 15, **dadurch gekennzeichnet, dass** die Auswerteschaltung (17) über eine Stromstatusausgabe (18) verfügt.

## Claims

1. Semiconductor component having a low-side power switch (503), in which the control voltage is related to earth, and which a load (60) can be connected, and having a sense circuit (16) and an evaluation circuit (17) for detection and evaluation of the load current flowing through the power switch (503), **characterized in that** the sense circuit (16) is monolithically integrated on the same chip as the power switch (503), and the high-voltage side of the sense circuit (16) is connected to the power switch (503), **in that** the sense signal is supplied to the evaluation circuit (17) via high-resistance resistors (501, 502), and **in that** the high-resistance resistors (501, 502) are monolithically integrated on the same chip as the power switch (503), and **in that** the power switch is subdivided into a part (402) with a small surface area and a part (401) with a larger surface area, with the part with the smaller surface area forming at least one sense cell (402), and the part with the larger surface area forming the main cell (401) of the power switch.

2. Semiconductor component according to Claim 1, **characterized in that** the sense circuit comprises a sense resistor (16) to which the load (16) is connected in series, and **in that** the voltage across the sense resistor (16) is tapped off as a sense signal and is supplied to the evaluation circuit (17).

3. Semiconductor component according to Claim 2, **characterized in that** the sense resistor (16) is formed from a semiconductive material, preferably from polysilicon.

4. Semiconductor component according to one of Claims 1 or 2, **characterized in that** the sense resistor is formed from metal.

5. Semiconductor component according to Claim 4, **characterized in that** the high-resistance resistors (501, 502) are formed from a semiconductive material, preferably from polysilicon.

6. Semiconductor component according to one of Claims 4 or 5, **characterized in that** the sense resistor (16) is connected between the load (60) and the sense cell (402), and the main cell (401) is connected directed to the load (60).

7. Semiconductor component according to Claim 6, **characterized in that** the sense cell (402) and the main cell (401) have similar electrical operating points, **in that** the voltage drop across the sense resistor (16) is small in comparison to the potential difference between the load-side voltage tap (42) on the sense resistor (16) and earth.

8. Semiconductor component according to one of Claims 6 or 7, **characterized in that** the sense cell (402) comprises a part of the high-voltage finger of the power switch, with the diffusion, which forms the high-voltage-side finger, of the high-voltage finger being interrupted between the sense cell (402) and the main cell (401).

9. Semiconductor component according to Claim 8, **characterized in that** the sense cell (402) comprises the tip of the high-voltage finger.

10. Semiconductor component according to one of Claims 8 or 9, **characterized in that** the sense resistor (16) is arranged between the metallisation of the high-voltage finger (403) of the sense cell (402) and the metallisation of the high-voltage finger (404) of the main cell (401).

11. Semiconductor component having a bipolar transistor as a power switch according to one of Claims 6 to 10, **characterized in that** the sense cell comprises a part of the emitter of the bipolar transistor, and **in that** the sense resistor is connected on one side to the emitter of the sense cell and on the other side to the emitter of the main cell.

12. Semiconductor component having a DMOS transistor as a power switch according to one of Claims 6 to 10, **characterized in that** the sense cell comprises a part of the drain region of the DMOS transistor, and **in that** the sense resistor is connected on one side to the drain region of the sense cell and on the other side to the drain region of the main cell.

13. Semiconductor component having a lateral insulated gate bipolar transistor, IGBT, as the power switch according to one of Claims 6 to 10, **characterized in that** the sense cell comprises a part of the anode of the lateral IGBT, and **in that** the sense resistor is connected on one side to the anode of the sense cell and on the other side to the anode of the main cell.

14. Semiconductor component having a lateral/vertical insulated gate bipolar transistor, IGBT, as the power switch according to one of Claims 6 to 10, **characterized in that** the sense cell comprises a part of the anode of the lateral/vertical IGBT, and **in that** the sense resistor is connected on one side to the anode of the sense cell and on the other side to the anode of the main cell.

15. Semiconductor component according to one of Claims 1 to 14, **characterized in that** the current through the power switch (503) can be regulated with the aid of the evaluation circuit (17).

16. Semiconductor component according to one of Claims 1 to 15, **characterized in that** the evaluation circuit (17) has a current status output (18).

## Revendications

1. Composant semi-conducteur comportant un commuteur de puissance (503), côté bas, dont la tension de commande est rapportée à la masse, sur lequel on peut brancher une charge (60) ainsi qu'un circuit de détection (16) et un circuit d'exploitation (17) pour détecter et exploiter le courant de charge traversant le commutateur de puissance (503),
**caractérisé en ce que**
le circuit de détection (16) est intégré de manière monolithique dans la puce du commutateur de puissance (503) et le circuit de détection (16) est raccordé du côté haute tension au commutateur de puissance (503), le signal de détection étant appliqué au circuit d'exploitation (17) par des résistances fortement ohmiques (501, 502) intégrées de manière monolithique dans la puce du commutateur de puissance (503) qui est réparti en une partie (402) de petite surface et une partie (401) de grande surface,
la partie de petite surface formant au moins une cellule de détection (402) et la partie de grande surface formant la cellule principale (401) du commutateur de puissance.

2. Composant semi-conducteur selon la revendication 1,
**caractérisé en ce que**
le circuit de détection comprend une résistance de détection (16) branchée en série avec la charge (60) et
la tension est prise comme signal de détection aux bornes de la résistance de détection (16) pour être appliquée au circuit d'exploitation (17).

3. Composant semi-conducteur selon la revendication 2,
**caractérisé en ce que**
la résistance de détection (16) est réalisée en une matière semiconductrice, notamment du polysilicium.

4. Composant semi-conducteur selon l'une des revendications 1 ou 2,
**caractérisé en ce que**
la résistance de détection est en métal.

5. Composant semi-conducteur selon la revendication 4,
**caractérisé en ce que**
les résistances fortement ohmiques (501, 502) sont formées dans un matériau semi-conducteur, de préférence du polysilicium.

6. Composant semi-conducteur selon l'une des revendications 4 ou 5,
**caractérisé en ce que**
la résistance de détection (16) est branchée entre la charge (60) et la cellule de détection (402) alors que la cellule principale (401) est reliée directement à la charge (60).

7. Composant semi-conducteur selon la revendication 6,
**caractérisé en ce que**
la cellule de détection (402) et la cellule principale (401) ont des points de fonctionnement électriques analogues **en ce que** la chute de tension aux bornes de la résistance de détection (16) est petite par rapport à la différence de potentiel entre la prise de tension du côté de la charge (42) de la résistance de détection (16) et la masse.

8. Composant semi-conducteur selon l'une des revendications 6 ou 7,
**caractérisé en ce que**
la cellule de détection (402) comprend une partie du doigt du commutateur de puissance mis à la haute tension et la diffusion formant le doigt du côté de la haute tension, est interrompue entre la cellule de détection (402) et la cellule principale (401).

9. Composant semi-conducteur selon la revendication 8,
**caractérisé en ce que**
la cellule de détection (402) comprend la pointe du doigt mis à la haute tension.

10. Composant semi-conducteur selon l'une des revendications 8 ou 9,
**caractérisé en ce que**
la résistance de détection (16) est installée entre la métallisation du doigt (403) de la cellule de détection (402) mise à la haute tension et la métallisation du doigt (404) de la cellule principale (401) mise à la haute tension.

11. Composant semi-conducteur comportant un transistor bipolaire comme commutateur de puissance selon l'une des revendications 6 à 10,
**caractérisé en ce que** la cellule de détection comprend une partie de l'émetteur du transistor bipolaire et la résistance de détection est reliée d'un côté à l'émetteur de la cellule de détection et de l'autre à l'émetteur de la cellule principale.

12. Composant semi-conducteur comportant un transistor DMOS comme commutateur de puissance selon l'une des revendications 6 à 10,
**caractérisé en ce que**
la cellule de détection comprend une partie de la zone de drain du transistor DMOS et la résistance de détection est reliée d'un côté à la zone de drain de la cellule de détection et de l'autre côté à la zone de drain de la cellule principale.

13. Composant semi-conducteur ayant un transistor bipolaire latéral à porte isolée IGBT comme commutateur de puissance selon l'une des revendications 6 à 10,
**caractérisé en ce que**
la cellule de détection comprend une partie de l'anode du transistor IGBT latéral et
la résistance de détection est reliée d'un côté à l'anode de la cellule de détection et de l'autre à l'anode de la cellule principale.

14. Composant semi-conducteur ayant un transistor latéral/vertical bipolaire à porte isolée IGBT comme commutateur de puissance selon l'une des revendications 6 à 10,
**caractérisé en ce que**
la cellule de détection comprend une partie de l'anode du transistor latéral/vertical IGBT et la résistance de détection est d'une part reliée à l'anode de la cellule de détection et de l'autre à l'anode de la cellule principale.

15. Composant semi-conducteur selon l'une des revendications 1 à 14,
**caractérisé en ce que**
le courant traversant le commutateur de puissance (503) se règle à l'aide du circuit d'exploitation (17).

16. Composant semi-conducteur selon l'une des revendications 1 à 15,
**caractérisé en ce que**
le circuit d'exploitation (17) comporte une sortie d'état de courant (18).
